(19) Europäisches Patentamt
European Patent Office
Office européen des brevets

(11) EP 2 835 909 A1

(12) **EUROPEAN PATENT APPLICATION**
published in accordance with Art. 153(4) EPC

(43) Date of publication:
**11.02.2015 Bulletin 2015/07**

(21) Application number: **13769395.8**

(22) Date of filing: **15.01.2013**

(51) Int Cl.:
***H03M 13/19*** *(2006.01)*

(86) International application number:
**PCT/JP2013/050568**

(87) International publication number:
**WO 2013/145811 (03.10.2013 Gazette 2013/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **26.03.2012 JP 2012069362**

(71) Applicant: **Mitsubishi Electric Corporation**
**Tokyo 100-8310 (JP)**

(72) Inventors:
- **MATSUMOTO,Wataru**
  **Tokyo 1008310 (JP)**
- **MIYATA, Yoshikuni**
  **Tokyo 1008310 (JP)**
- **SUGIHARA, Kenya**
  **Tokyo 1008310 (JP)**

(74) Representative: **Tischner, Oliver**
**Lavoix Munich**
**Bayerstrasse 83**
**80335 München (DE)**

# (54) RECEIVER, COMMUNICATION DEVICE AND COMMUNICATION METHOD

(57) A Sum-product decoder 17 carries out soft-decision iterative decoding on a received signal s'(t) received by a signal receiving unit 12 by using an extended check matrix $H_d$ which is a combination of a matrix D in which differential modulation by a differential modulator 3 is replaced by a check matrix and a check matrix H for error correcting codes to carry out error correction decoding on an information sequence $b_i$.

FIG.1

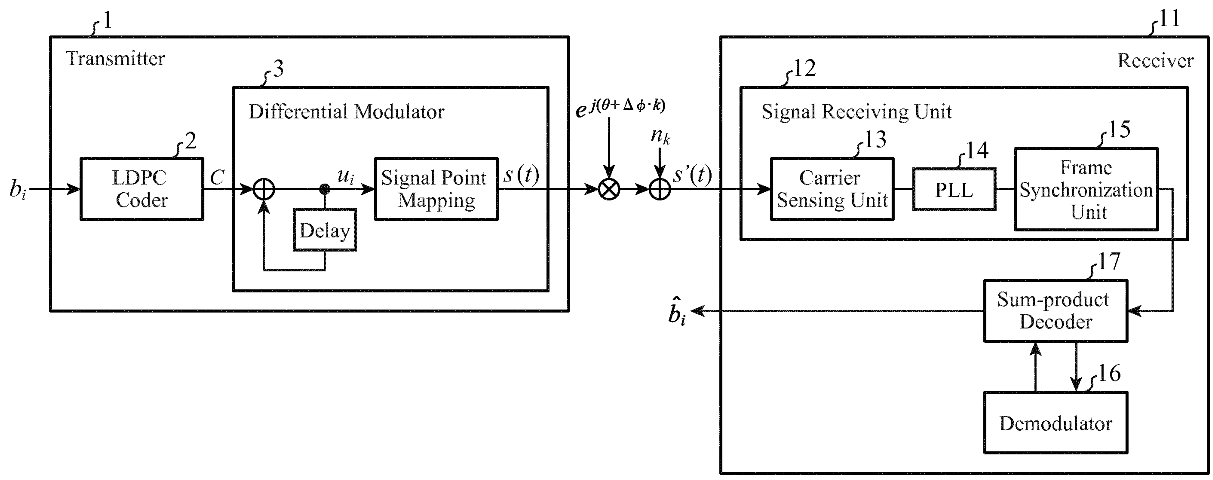


EP 2 835 909 A1

## Description

FIELD OF THE INVENTION

The present invention relates to a receiver for, a communication device for, and a communication method of receiving a modulated signal of a codeword series outputted to a transmission line from a transmitter, carries out soft-decision iterative decoding on the received signal, and carries out error correction decoding on an information sequence.

BACKGROUND OF THE INVENTION

A conventional communication device carries out establishment of phase synchronization by using, for example, a phase synchronization method disclosed by the following nonpatent reference 1. According to the synchronization method disclosed by the nonpatent reference 1, a transmitter prepares N signals (preambles or pilot signals) whose phases are inverted from each other and transmits these N signals, as shown in Fig. 4. When receiving the N signals outputted from the transmitter, a receiver detects the phase inversions from the N signals and uses a signal showing the phase inversions as a synchronization signal. More specifically, the receiver demodulates the data of a modulated wave in synchronization with the synchronization signal.

Usually, in order to detect phase inversions correctly and to be able to establish synchronization even in the case of a communication channel with many noises, the number N of signals needs to be set to be 10 or more in many cases. N signals whose phases are inverted from each other are transmitted before a data signal is transmitted or during a time interval between a time when a data signal is transmitted continuously and the next time when a data signal is transmitted continuously, so that synchronization is established.

Next, coding and decoding which use an LDPC (low-density parity-check) code will be explained. Fig. 5 is a block diagram showing a conventional communication device. Referring to Fig. 5, a coder and a modulator are components of a transmitter, and a demodulator and a Sum-product decoder are components of a receiver.

The coder of the transmitter prepares a check matrix H in advance, and, in the case in which the check matrix H is an LDGM (Low-Density Generation Matrix), and generates a codeword series C by using the check matrix H when receiving a message ($b_1$, $b_2$, ..., $b_k$) having an information length of k.

$$H=(n-k)\times n$$

$$C=\{(b_1,\ b_2,\ \ldots,\ b_k,\ p_1,\ p_2,\ \ldots,\ p_{n-k})$$
$$:H(b_1,\ b_2,\ \ldots,\ b_k)^t=0\}$$

where k is the information length and n is the codeword length. Further, $p_1$, $p_2$, ..., and $p_{n-k}$ are a parity sequence.

After the coder generates a codeword series C, the modulator of the transmitter carries out digital modulation (e.g., modulation according to BPSK, QPSK, multi-valued QAM or the like) on the codeword series C, and transmits the modulated signal to the receiver via a communication channel. When receiving the modulated signal transmitted from the transmitter, the demodulator of the receiver carries out digital demodulation (e.g., demodulation according to BPSK, QPSK, multi-valued QAM, or the like) on the received signal. The Sum-product decoder of the receiver carries out soft-decision iterative decoding on the received signal while using the demodulated results acquired by the demodulator so as to estimate a message ($b_1$, $b_2$, ..., $b_k$) having the information length of k.

Although a portion for establishing phase synchronization is omitted in the communication device shown in Fig. 5, the structure of a communication device equipped with a portion for establishing phase synchronization is as shown in Fig. 6. However, an example of handling a synchronization unit and an error correcting unit independently is shown in the communication device of Fig. 6. Fig. 7 is an explanatory drawing showing a frame structure applied to the communication device of Fig. 6. In the communication device of Fig. 6, after the synchronization unit completes symbol synchronization during a preamble and fixes the synchronous phase to the estimated phase which is the result of the symbol synchronization, frame synchronization according to a unique word is carried out and, after that, a decoding process of decoding an LDPC code is carried out. Therefore, the decoding performance for decoding an LDPC code depends on errors in the estimated phase of the symbol synchronization.

Hereafter, the processing carried out by the communication device of Fig. 6 will be explained concretely. First, parameters regarding a system model are defined. Hereafter, it is assumed that an AWGN transmission line is provided as a communication channel. When receiving an information sequence $b_i$ which is a message ($b_1$, $b_2$, ..., $b_k$), an LDPC coder carries out error correction coding on the information sequence $b_i$ so as to generate a codeword series C.

$$b_i \in \{0,\ 1\},\ i=1,\ 2,\ \ldots,\ \text{and}\ L_c$$

$$C=\{(b_1,\ b_2,\ \ldots,\ b_k,\ p_1,\ p_2,\ \ldots,\ p_{n-k}) : H(b_1,\ b_2,\ \ldots,\ b_k)^t=0\}$$

After the LDPC coder generates a codeword series C, a modulator generates a transmission signal $u_i$ from the information sequence $b_i$ which is the elements of the codeword series C and a parity sequence $p_{n-k}$, as shown in the following equation (1).

For $1 \leq i \leq k$

$$u_i = \begin{cases} 1 & (b_i = 0) \\ -1 & (b_i = 1) \end{cases},$$

For $k < i \leq n$

$$u_i = \begin{cases} 1 & (p_{i-k} = 0) \\ -1 & (p_{i-k} = 1) \end{cases}$$

After generating the transmission signal $u_i$, the modulator generates a codeword series $c_k$ (k=1, 2, ..., $L_c$/2) from the transmission signal $u_i$, as shown in the following equation (2).

$$c_k = u_{2k-1} + j \cdot u_{2k} \qquad (2)$$

After generating a codeword series $c_k$ from the transmission signal $u_i$, the modulator carries out QPSK modulation on the codeword series $c_k$, and outputs the QPSK modulated signal s (t) , as shown in the following equation (3), to the AWGN transmission line.

$$s(t) = \mathrm{Re}\left[c_k \cdot e^{-j2\pi f_c t}\right] \qquad (3)$$

$$t = T_s \cdot i, (i = 1,2,\ldots,2k-1,2k,\ldots,L_c)$$

$$T_s = 1/(4f_c)$$

where Re shows the real part, $f_c$ shows a carrier frequency, t shows a time, and $T_s$ shows a sample interval. The modulator outputs the QPSK modulated signal s (t) to the AWGN transmission line in the order of $t=T_s \cdot i$ (i=1, 2, ..., 2k-1, 2k, ..., and $L_c$). Fig. 8 is an explanatory drawing showing the transmission sequence on a time axis.

It is assumed that the AWGN transmission line is exposed to an additive white Gaussian noise (AWGN) $n_k$ during transmission of the QPSK modulated signal s(t).

$$E\left[\left|n_k\right|^2\right] = 2\sigma_0^2$$

where $\sigma_0^2$ is the variance of the Gaussian noise. Further, it is assumed that because a phase error $\theta$ due to sample point errors in the transmitter and the receiver and a carrier wave frequency error $\Delta\phi$ due to a frequency error in an oscillator disposed between the transmitter and the receiver are added to the QPSK modulated signal s(t), a modulated signal as shown in the following equation (4) is received by the receiver as a received signal s' (t) .

$$s'(t) = \mathrm{Re}\left\{\left[e^{j(\theta+\Delta\phi\cdot k)} c_k \cdot e^{-j2\pi f_c t}\right] e^{-j2\pi f_c t'}\right\} \quad (4)$$

The demodulator of the receiver demodulates the received signal s' (t) at the sample intervals of $T_s$ and in the order of $t=T_s \cdot i$ (i=1, 2, ..., 2k-1, 2k, ..., and $L_c$), and acquires a received codeword sequence $y_k$ as shown in the following equation (5).

$$y_k = e^{j(\theta-\Delta\phi\cdot k)} c_k + n_k = r_{2k-1} + j \cdot r_{2k} \quad (5)$$

where $r_{2k-1}$ and $r_{2k}$ are complex elements of the received codeword sequence $y_k$.

When receiving the received codeword sequence $y_k$ from the demodulator, the Sum-product decoder of the receiver carries out soft-decision iterative decoding on the received signal s' (t) while using the received codeword sequence $y_k$, and carries out error correction decoding on the information sequence $b_i$. As a result, a message ($b_1$, $b_2$, ..., $b_k$) is outputted from the Sum-product decoder.

[The decoding performance for decoding an LDPC code according to phase errors]

Fig. 9 is an explanatory drawing showing the LDPC decoding characteristics in a state in which a fixed phase error exists. It can be seen that although up to about 10 degrees of fixed phase error can be permitted if the amount of $Eb/N_0$ degradation resulting from a fixed phase error phi which can achieve both the bit error rate characteristics required for the communication device and the frame error rate required for the communication device is 0.5dB ($Eb/N_0 \approx 2$dB) when the bit error rate characteristics is BER=$10^{-4}$ and the frame error rate is FER=$10^{-2}$, the degradation becomes large when the fixed phase error is larger than about 10 degrees.

For example, when the communication device carries out optical communications, remarkable phase variations occur and hence this results in a major factor of degradation, as shown in Fig. 9. Therefore, there are many cases in which in a communication device or the like that carries optical communications, a differential modulator (refer to Fig. 10) having strong resistance to phase variations is mounted in a transmitter, and digital modulation is carried out on a codeword sequence $c_k$.

RELATED ART DOCUMENT

Nonpatent reference

Nonpatent reference 1: Matsumoto and Imai, "Blind Synchronization Scheme with Low-Density Parity-Check (LDPC) Codes", the Institute of Electronics, Information and Communication Engineers Paper Magazine B Vol.J86-B No.10 pp.2065-2078 October, 2003

SUMMARY OF THE INVENTION

PROBLEMS TO BE SOLVED BY THE INVENTION

Because conventional communication devices are constructed as above, mounting a differential modulator having strong resistance to phase variations in a transmitter in the case in which remarkable phase variations occur can reduce the influence of phase variations. However, in the case in which a transmitter includes a differential modulator, when a receiver carries out differential detection, if, for example, a 1-bit bit error occurs, this bit error is doubled and becomes a 2-bit bit error. A problem is therefore that there occurs degradation of about 3dB of SNR ratio to the bit error rate (BER) after the detection.

The present invention is made in order to solve the above-mentioned problem, and it is therefore an object of the present invention to provide a receiver, a communication device, and a communication method capable of preventing degradation in the SNR ratio to the bit error rate even though a differential modulator having strong resistance to phase variations is mounted in a transmitter.

## MEANS FOR SOLVING THE PROBLEM

In accordance with the present invention, there is provided a receiver in which a signal receiver that receives a modulated signal of a codeword series outputted from a transmitter to a transmission line is disposed, and an error correction decoder carries out soft-decision iterative decoding on the received signal received by the signal receiver by using an extended check matrix which is a combination of a matrix in which differential modulation carried out by the transmitter is replaced by a check matrix and a check matrix for error correcting codes to carry out error correction decoding on an information sequence.

## ADVANTAGES OF THE INVENTION

Because according to the present invention, the signal receiver that receives a modulated signal of a codeword series outputted from the transmitter to the transmission line is disposed, and the error correction decoder carries out soft-decision iterative decoding on the received signal received by the signal receiver by using the extended check matrix which is a combination of the matrix in which the differential modulation carried out by the transmitter is replaced by a check matrix and the check matrix for error correcting codes to carry out error correction decoding on the information sequence, there is provided an advantage of being able to prevent degradation in the SNR ratio to the bit error rate even though a differential modulator having strong resistance to phase variations is mounted in the transmitter.

## BRIEF DESCRIPTION OF THE FIGURES

[Fig. 1] Fig. 1 is a block diagram showing a communication device in accordance with Embodiment 1 of the present invention;

[Fig. 2] Fig. 2 is a block diagram showing processing (communication method) carried out by the communication device in accordance with Embodiment 1 of the present invention;

[Fig. 3] Fig. 3 is an explanatory drawing showing a relationship between a received signal and a regression line;

[Fig. 4] Fig. 4 is an explanatory drawing showing a synchronization method disclosed by nonpatent reference 1;

[Fig. 5] Fig. 5 is a block diagram showing a conventional communication device;

[Fig. 6] Fig. 6 is a block diagram showing a communication device equipped with a portion in which phase lock is established;

[Fig. 7] Fig. 7 is an explanatory drawing showing a frame structure applied to the communication device shown in Fig. 6.

[Fig. 8] Fig. 8 is an explanatory drawing showing a transmission sequence on a time axis.

[Fig. 9] Fig. 9 is an explanatory drawing showing LDPC decoding characteristics in a state in where a fixed phase error exists; and

[Fig. 10] Fig. 10 is a block diagram showing a differential modulator.

## EMBODIMENTS OF THE INVENTION

Hereafter, in order to explain this invention in greater detail, the preferred embodiments of the present invention will be described with reference to the accompanying drawings. Embodiment 1.

Fig. 1 is a block diagram showing a communication device in accordance with Embodiment 1 of the present invention. Referring to Fig. 1, a transmitter 1 is comprised of an LDPC coder 2 and a differential modulator 3. The LDPC coder 2 of the transmitter 1 carries out a process of performing error correction coding on an information sequence so as to generate a codeword series. The differential modulator 3 of the transmitter 1 carries out a process of performing differential modulation on the codeword series generated by the LDPC coder 2, and outputting a modulated signal of the codeword series to a transmission line.

A receiver 11 is comprised of a signal receiving unit 12, a demodulator 16, and a Sum-product decoder 17.

The signal receiving unit 12 is comprised of a carrier sensing unit 13, a PLL (Phase Locked Loop) 14, and a frame synchronization unit 15, and carries out a process of receiving the modulated signal of the codeword series outputted from the transmitter 1 to the transmission line. The signal receiving unit 12 constructs a signal receiver.

The carrier sensing unit 13 carries out a process of detecting the modulated signal of the codeword series outputted from the transmitter 1 to the transmission line. The PLL 14 is a phase locked loop and is a circuit that establishes phase synchronization of the received signal which is the modulated signal detected by the carrier sensing unit 13. The frame synchronization unit 15 is a circuit that recognizes a start of significant data when detecting a predetermined bit pattern from the received signal in order to establish synchronization between the transmit side and the receive side.

The demodulator 16 carries out a process of demodulating the received signal received by the signal receiving unit 12. The Sum-product decoder 17 is an error correction decoder that carries out soft-decision iterative decoding on the received signal received by the signal receiving unit 12 by using an extended check matrix $H_d$ which is a combination of a matrix D in which the differential modulation by the differential modulator 3 is replaced by a check matrix and a check matrix H for error correcting codes to carry out error correction decoding on an information sequence. An error correction decoder is comprised of the demodulator 16 and the Sum-product decoder 17.

In the example shown in Fig. 1, although it is assumed that the LDPC coder 2, the differential modulator 3, the signal receiving unit 12, the demodulator 16, and the Sum-product decoder 17 which are the components of the communication device consist of hardware for exclusive use (e.g., a semiconductor integrated circuit equipped with a CPU, a one chip microcomputer or the like), each of the transmitter 1 and the receiver 11 can alternatively consist of a computer. In the case in which the transmitter 1 consists of a computer, a program in which the processes carried out by the LDPC coder 2 and the differential modulator 3 are described can be stored in a memory of the computer, and a CPU of the computer can be made to execute the program stored in the memory. Further, in the case in which the receiver 11 consists of a computer, a program in which the processes carried out by the signal receiving unit 12, the demodulator 16, and the Sum-product decoder 17 are described can be stored in a memory of the computer, and a CPU of the computer can be made to execute the program stored in the memory. Fig. 2 is a block diagram showing processing (communication method) carried out by the communication device in accordance with Embodiment 1 of the present invention.

Next, the operation of the communication device will be explained. In this Embodiment 1, there is proposed a method of, in order to carry out recovery of degradation in the synchronization performance due to a phase error and a carrier wave frequency error on the condition that the transmitter 1 carries out differential modulation, estimating the phase error and the carrier wave frequency error by using a new LDPC decoding method corresponding to a check matrix taking into consideration differential modulation in a state in which synchronization cannot be established for the sample timing and the carrier frequency, thereby enhancing the error correction ability.

To this end, in accordance with this Embodiment 1, the differential modulation which the transmitter 1 carries out is expressed by a check matrix, and decoding is enabled by means of LDPC decoding or turbo decoding. More specifically, while a conventional communication device carries out decoding by using only a check matrix H of LDPC codes, the communication device in accordance with this Embodiment 1 carries out the decoding by using an extended check matrix $H_d$ which is a combination of a matrix D in which the differential modulation is replaced by a check matrix and a check matrix H for error correcting codes.

$$H_d = \left[ \frac{I \mid D}{H \mid 0} \right] \qquad (6)$$

where D is the check matrix corresponding to the differential modulation, I is a unit matrix, 0 is a zero matrix, and H is the check matrix for error correcting codes.

In this case, when the differential modulation which the transmitter 1 carries out is, for example, differential BPSK, a concrete example of the extended check matrix $H_d$ is given by the following equation (7). A codeword sequence for the extended check matrix $H_d$ is shown above the equation (7). The codeword sequence consists of an information sequence b, a parity sequence P, and a transmission codeword sequence U, and the sequence outputted from the transmitter 1 to the transmission line is only the transmission codeword sequence U.

Codeword Sequence for Proposed Check Matrix Shown Below

| | | |
|---|---|---|
| Information Sequence b | P | Transmission Code Sequence U |

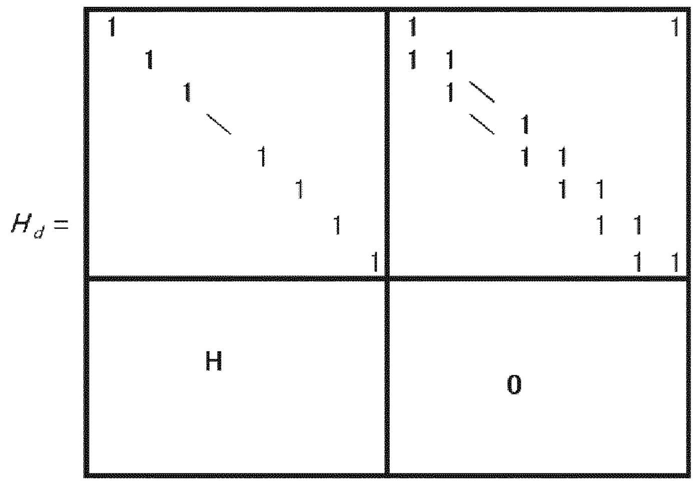

(7)

Further, when the differential modulation which the transmitter 1 carries out is, for example, differential QPSK, a concrete example of the extended check matrix $H_d$ is given by the following equation (8). A codeword sequence for the extended check matrix $H_d$ is shown above the equation (8). The codeword sequence consists of an information sequence b, a parity sequence P, and a transmission codeword sequence U, and the sequence outputted from the transmitter 1 to the transmission line is only the transmission codeword sequence U.

Codeword Sequence for Proposed Check Matrix Shown Below

| Information Sequence b | P | Transmission Code Sequence U |
|---|---|---|

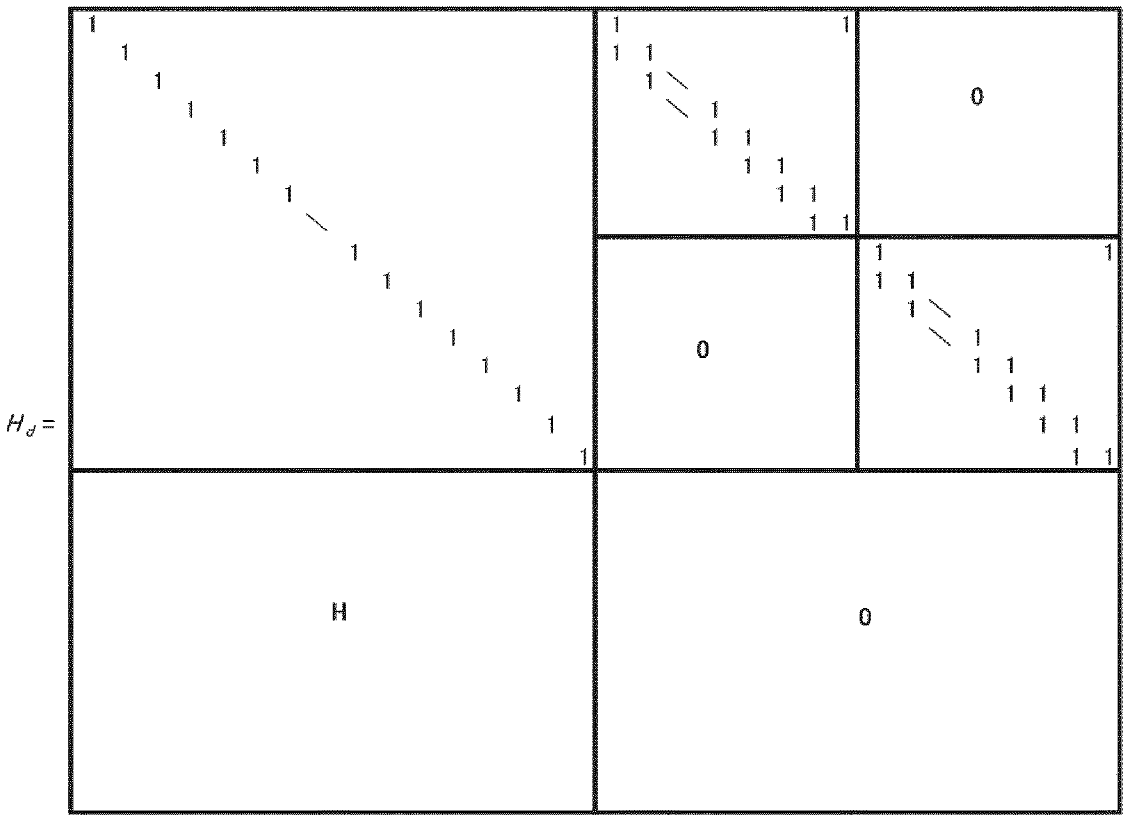


(8)

Therefore, because the receiver 11 receives the log-likelihood ratio of the received value to the transmission codeword sequence U, but does not receive anything regarding the information sequence b and the parity sequence P, the receiver carries out calculation by receiving a state in which both the probability of "1" and the probability of "0" are 50% (log-likelihood ratio=zero value) as an input. Particularly, in a concrete calculation which will be mentioned below, the value of the information sequence b is estimated by using a decoding method of decoding LDPC from the log-likelihood ratio of the received value to the transmission codeword sequence U. In this Embodiment 1, although a method of carrying out a sum-product algorithm using the above-mentioned extended check matrix $H_d$ is used, in accordance with this method, the same performance can be offered by using either of a probability domain sum-product decoding method and a logarithm domain sum-product decoding method. In this Embodiment 1, although for convenience' sake, an explanation will be made by assuming that a logarithm domain sum-product decoding method is used, it is needless to say that a probability domain sum-product decoding method can be alternatively used. Further, although an example of using LDPC codes will be explained in this Embodiment 1, any decoding method can be applied as long as the decoding method is an LDPC decoding method,

Hereafter, the processing carried out by the communication device of Fig. 1 will be explained concretely. Hereafter, it is assumed that an AWGN transmission line is provided as the communication channel. First, when receiving an information sequence $b_i$ which is a message ($b_1$, $b_2$, ..., $b_k$) having an information length of k, the LDPC coder 2 of the transmitter 1 carries out error correction coding on the information sequence $b_i$ so as to generate a codeword sequence C (an information sequence b + a parity sequence P + a transmission code sequence U) (step ST1 of Fig. 2).

$$C=\{(b_1, b_2, \ldots, b_k, p_1, p_2, \ldots, p_{n-k}) : H(b_1, b_2, \ldots, b_k)^t=0\}$$

After the LDPC coder 2 generates the codeword sequence C, the differential modulator 3 of the transmitter 1 carries out differential modulation on the codeword sequence C, and outputs a modulated signal s(t) of the codeword sequence C to the transmission line (step ST2).

More specifically, when carrying out differential modulation on the codeword sequence C, the differential modulator 3 determines a transmission code sequence $u_i$ from the information sequence $b_i$ and the parity sequence $p_i$ which are included in the codeword sequence C, as shown in the following equation (9).

(1) When $1 \leq i \leq k$

$$v_i = (b_i + b_{i-1}) \mod 2$$

(2) When $i = k + 1$

$$v_i = (p_{i-k} + b_{i-1}) \mod 2$$

(3) When $k + 2 \leq i \leq n$

$$v_i = (p_{i-k} + p_{i-k-1}) \mod 2$$

$$u_i = \begin{cases} 1 & (v_i = 0) \\ -1 & (v_i = 1) \end{cases} \qquad (9)$$

After determining the transmission code sequence $u_i$, the differential modulator 3 generates a codeword sequence $c_k$ from the transmission code sequence $u_i$, as shown in the following equation (10).

$$c_k = u_{2k-1} + j \cdot u_{2k} \qquad (10)$$

After generating the codeword sequence $c_k$ from the transmission signal $u_i$, the differential modulator 3 carries out QPSK modulation on the codeword sequence $c_k$, and outputs a QPSK modulated signal s(t) as shown in the following equation (11) to the AWGN transmission line. In this embodiment, although the differential modulator carries out QPSK modulation on the codeword sequence $c_k$, the modulation is not limited to QPSK modulation and, for example, the differential modulator can carry out BPSK modulation on the codeword sequence $c_k$.

$$s(t) = \mathrm{Re}\left[c_k \cdot e^{-j2\pi f_c t}\right] \qquad (11)$$

$$t = T_s \cdot i, (i = 1,2,...,2k-1,2k,...,L_c)$$

$$T_s = 1/(4f_c)$$

where Re shows the real part, $f_c$ shows the carrier frequency, t shows the time, and $T_s$ shows the sample interval. The differential modulator 3 outputs the QPSK modulated signal s (t) to the AWGN transmission line in the order of $t=T_s \cdot i$ (i=1, 2, ..., 2k-1, 2k, ..., and $L_c$) . Fig. 8 shows the transmission sequence on a time axis.

It is assumed that the AWGN transmission line is exposed to an additive white Gaussian noise (AWGN) $n_k$ during transmission of the QPSK modulated signal s(t).

$$E\left[\left|n_k\right|^2\right] = 2\sigma_0^2$$

where $\sigma_0^2$ is the variance of the Gaussian noise. Further, it is assumed that because a phase error $\theta$ due to sample point errors in the transmitter 1 and the receiver 11 and a carrier wave frequency error $\Delta\phi$ due to a frequency error in an oscillator disposed between the transmitter 1 and the receiver 11 are added to the QPSK modulated signal s(t), a modulated signal as shown in the following equation (12) is received by the receiver 11 as a received signal s'(t).

When the signal receiving unit 12 receives the modulated signal shown in the equation (12) as the received signal s' (t) (step ST3), the Sum-product decoder 17 of the receiver 11 carries out soft-decision iterative decoding on the received signal s' (t) received by the signal receiving unit 12 by using the extended check matrix $H_d$ which is a combination of the matrix D in which the differential modulation by the differential modulator 3 is replaced by a check matrix and the check matrix H for error correcting codes to carry out error correction decoding on the information sequence $b_i$ (step ST4).

Hereafter, the processing carried out by the demodulator 16 and the Sum-product decoder 17 will be explained concretely. The processing is divided roughly into (A) a phase error correcting process using soft decision, and (B) a typical Sum-product decoding process.

(A) The phase error correcting process using soft decision

(first step)

(A-1) Initialization

First, a pseudo-posterior log-likelihood ratio to the information sequence $b_i$ after the $I_A$-th time iterative decoding in the logarithm domain Sum-product decoding which is carried out in the following (A-2) is set to $L_u^{IA}(b_i)$. Further, a pseudo-posterior log-likelihood ratio to the parity sequence $p_i$ after the $I_A$-th time iterative decoding in the logarithm domain Sum-product decoding which is carried out in (A-2) is set to $L_u^{IA}(p_i)$. Further, a pseudo-posterior log-likelihood ratio to the transmission code sequence $u_i$ after the $I_A$-th time iterative decoding in the logarithm domain Sum-product decoding which is carried out in (A-2) is set to $L_u^{IA}(u_i)$. However, only an initial value $L_u^0$ $(u_i)$ of the pseudo-posterior log-likelihood ratio to the transmission code sequence $u_i$ is set to the log-likelihood ratio acquired from the AWGN communication channel, as shown in the following equation (13).

In this case, the initial values $L_u^0$ $(u_i)$ and $L_u^0$ $(v_i)$ are given by the following equation (14).

$$L_u^0(u_i) = L_u^0(v_i) := \ln\frac{\Pr\{v_i = 0 \mid \mathbf{r}\}}{\Pr\{v_i = 1 \mid \mathbf{r}\}} \qquad (14)$$

Further, an initial value $L_u^0$ $(b_i)$ of the pseudo-posterior log-likelihood ratio to the information sequence $b_i$ is set as shown in the following equation (15).

$$L_u^0(b_i) := \ln \frac{\Pr\{b_i = 0 \mid \mathbf{r}\}}{\Pr\{b_i = 1 \mid \mathbf{r}\}} = 0 \qquad (15)$$

In addition, an initial value $L_u^0$ $(p_i)$ of the pseudo-posterior log-likelihood ratio to the parity sequence $p_i$ is set as shown in the following equation (16).

$$L_u^0(p_i) := \ln \frac{\Pr\{p_i = 0 \mid \mathbf{r}\}}{\Pr\{p_i = 1 \mid \mathbf{r}\}} = 0 \qquad (16)$$

where the variance of the AWGN noise is expressed by $\sigma_0^2$, and the block of the received symbol is expressed by r: $[r_1, r_2, ..., r_{Le}]$. Further, a variable $I_A$ showing an initial iteration counter is set to "1", and a variable showing a maximum number of iterations is set to $I_A^{max}$.

(A-2) Logarithm domain Sum-product decoding

Assuming that the pseudo-posterior log-likelihood ratio $L_u^{1A}(u_i)$ to the transmission code sequence $u_i$, other than the initial value $L_u^0$ $(b_i)$, is the log-likelihood ratio of the communication channel after the phase error correction is carried out in (A-3) to (A-6), which will be mentioned below, the Sum-product decoder 17 carries out logarithm domain Sum-product decoding only once by using the extended check matrix $H_d$.

(A-3) Calculation of a soft decision bit

After carrying out the logarithm domain Sum-product decoding, the Sum-product decoder 17 estimates a soft decision bit $u_k$ hat (because the symbol of "^" attached to the top of the characters of $u_k$ cannot be written in the text because this application is an electronic one, a character string to which the symbol is attached is written as " $u_k$ hat") by using $L_u^{IA}(u_k)$ of the coded signal $\{u_k\}_{k=1}^{Lc}$ after $I_A$ iterations, as shown in the following equation (17).

$$\hat{u}_k := E\{u_k\} = \Pr\{u_k = +1\}\cdot 1 + \Pr\{u_k = -1\}\cdot(-1) = \frac{\exp(L_u^{I_A}(u_k))}{1+\exp(L_u^{I_A}(u_k))} + \frac{-1}{1+\exp(L_u^{I_A}(u_k))}$$
$$= \tanh\left(\frac{L_u^{I_A}(u_k)}{2}\right) \qquad (17)$$

(A-4) Estimation of a phase error using a minimum mean square error (MMSE) method

The Sum-product decoder 17 carries out estimation of a phase error using MMSE as follows. First, an estimated phase error is expressed by $\theta$ hat, and an estimated carrier wave frequency error is expressed by $\Delta\phi$ hat.

$$\hat{\theta}\left(-\pi < \hat{\theta} \le \pi\right)$$

$$\Delta\hat{\phi}\left(-\frac{2\pi}{T_s} < \Delta\hat{\phi} \le \frac{2\pi}{T_s}\right)$$

The Sum-product decoder 17 assumes that the following equation (18) is a regression line of k, and calculates the estimated phase error θ hat and the estimated carrier wave frequency error Δϕ hat which satisfy the following equation (19).

$$\hat{\theta}+\Delta\hat{\phi}\cdot k \qquad (18)$$

$$\hat{\theta}+\Delta\hat{\phi}\cdot k=\arg\min_{\hat{\theta},\Delta\hat{\phi}} E\left\{\left|\tan^{-1}\frac{\hat{u}_{2k}}{\hat{u}_{2k-1}}-(\hat{\theta}+\Delta\hat{\phi}\cdot k)\right|^{2}\right\} \qquad (19)$$

In this case, a soft decision codeword sequence having complex representation using the soft decision bit $u_k$ hat is expressed by c hat.

$$\hat{c}_k=\hat{u}_{2k-1}+j\cdot\hat{u}_{2k}$$

In this case, the phase error estimated using the soft decision bit $u_k$ hat is shown as in the following equation (20).

$$\tan^{-1}\frac{\mathrm{Im}[y_k/\hat{c}_k]}{\mathrm{Re}[y_k/\hat{c}_k]} \qquad (20)$$

where Re [·] shows the real part and Im [·] shows the imaginary part.

In order to calculate the estimated phase error θ hat and the estimated carrier wave frequency error Δϕ hat which satisfy the equation (19), what is necessary is just to solve the simultaneous equation acquired by partially differentiating the following equation (21) with θ hat and Δϕ hat and putting the results of the partial differentiations to be equal to 0 respectively.

$$S=\sum_{k=1}^{L_c/2}\left(\tan^{-1}\frac{\mathrm{Im}[y_k/c_k]}{\mathrm{Re}[y_k/c_k]}-\left(\hat{\theta}+\hat{\theta}\cdot k\right)\right)^{2} \qquad (21)$$

More specifically, by solving the simultaneous equation given by the following equations (22) and (23), the estimated phase error θ hat and the estimated carrier wave frequency error Δϕ hat can be calculated.

$$\frac{\partial S}{\partial\hat{\theta}}=-2\sum_{k-1}^{L_c/2}\left(\tan^{-1}\frac{\mathrm{Im}[y_k/c_k]}{\mathrm{Re}[y_k/c_k]}-\left(\hat{\theta}+\Delta\hat{\phi}\cdot k\right)\right)=0 \qquad (22)$$

$$\frac{\partial S}{\partial\hat{\phi}}=-2k\sum_{k=1}^{L_c/2}\left(\tan^{-1}\frac{\mathrm{Im}[y_k/c_k]}{\mathrm{Re}[y_k/c_k]}-\left(\hat{\theta}+\Delta\hat{\phi}\cdot k\right)\right)=0 \qquad (23)$$

Fig. 3 shows a relationship between the received signal $y_k$ and the regression line of the equation (18), and the phase error of the received signal $y_k$ draws an estimated straight line (straight line of phase error) as shown in Fig. 3.

(A-5) Correction of the phase error using a soft decision bit

After the Sum-product decoder 17 calculates the estimated phase error θ hat and the estimated carrier wave frequency error Δϕ hat, the demodulator 16 carries out a phase error correction and a carrier wave frequency error correction on the received signal $y_k$ by using the estimated phase error θ hat and the estimated carrier wave frequency error Δϕ hat so as to calculate a corrected received signal $y_k$ hat.

$$\begin{aligned}\hat{y}_k &= y_k \cdot e^{-j(\theta+\Delta\phi\cdot k)} \\ &= (r_{2k-1} + j\cdot r_{2k})\cdot(\cos(\theta+\Delta\phi\cdot k) - j\cdot\sin(\theta+\Delta\phi\cdot k))\end{aligned} \quad (24)$$

$$\hat{r}_{2k-1} = \mathrm{Re}\{(r_{2k-1} + j\cdot r_{2k})\cdot(\cos(\theta+\Delta\phi\cdot k) - j\cdot\sin(\theta+\Delta\phi\cdot k))\} \quad (25)$$

$$\hat{r}_{2k} = \mathrm{Im}\{(r_{2k-1} + j\cdot r_{2k})\cdot(\cos(\theta+\Delta\phi\cdot k) - j\cdot\sin(\theta+\Delta\phi\cdot k))\} \quad (26)$$

(A-6) Update of LLR

After the demodulator 16 calculates the corrected received signal $y_k$ hat, the Sum-product decoder 17 calculates the pseudo-posterior log-likelihood ratio $L_u^{lA}(u_i)$ to the transmission code sequence $u_i$ by temporarily correcting the phase error by using a soft decision bit, as shown in the following equation (27).

$$L_u^{l_A}(u_i) := \ln\frac{\Pr\{u_i = +1 \mid \hat{\mathbf{r}}\}}{\Pr\{u_i = -1 \mid \hat{\mathbf{r}}\}} = \frac{2\hat{r}_i}{\sigma_0^2} \quad (27)$$

where $\hat{\mathbf{r}}$ is the block of an estimated received symbol, and is $\hat{\mathbf{r}} := [\hat{r}_1, \hat{r}_2, \cdots, \hat{r}_{Lc}]^T$.

(B) Typical Sum-product decoding process (second step)

(B-1) Initialization after frame synchronization

First, a pseudo-posterior log-likelihood ratio to the information sequence $b_i$ after the $l_B$-th time iterative decoding in the typical logarithm domain Sum-product decoding in the second step is set to $L_u^{lB}(b_i)$. Further, a pseudo-posterior log-likelihood ratio to the parity sequence $p_i$ after the $l_B$-th time iterative decoding in the typical logarithm domain Sum-product decoding is set to $L_u^{lB}(p_i)$. Further, a pseudo-posterior log-likelihood ratio to the transmission code sequence $u_i$ after the $l_B$-th time iterative decoding in the typical logarithm domain Sum-product decoding is set to $L_u^{lB}(u_i)$.

Initial values of the pseudo-posterior log-likelihood ratios in the second step are set up as follows.

$$L_u^{lB=0}(b_i) = L_u^{lA}(b_i)$$

$$L_u^{lB=0}(p_i) = L_u^{lA}(p_i)$$

$$L_u^{lB=0}(u_i) = L_u^{lA}(u_i)$$

Further, a variable $l_B$ showing an initial iteration counter in the second step is set to "1", and a variable showing a maximum number of iterations is set to $I_B^{max}$.

(B-2) Sum-product decoding

The Sum-product decoder 17 carries out logarithm domain Sum-product decoding only once by using the pseudo-posterior log-likelihood ratios $L_u^{IB}(b_i)$, $L_u^{IB}(p_i)$, and $L_u^{IB}(u_i)$ and the extended check matrix $H_d$. The Sum-product decoder 17 outputs a temporary estimated word as the results of the logarithm domain Sum-product decoding.

Temporary estimated word $(\hat{b}_1,\hat{b}_2,...,\hat{b}_{L_h},\hat{p}_1,\hat{p}_2,...,\hat{p}_{L_p},\hat{v}_1,\hat{v}_2,...,\hat{v}_{L_p})$ (28) where $v_i = \begin{cases} 0 & (\hat{u}_i = 1) \\ 1 & (\hat{u}_i = -1) \end{cases}$.

(B-3) Parity check

When the temporary estimated word given by the equation (28) satisfies the following equation (29), the Sum-product decoder 17 outputs an information sequence shown in the following equation (30) and stops the Sum-product decoding.

(B-4) Increment of the counter

When the variable $I_B$ is equal to or smaller than $I_B^{max}$ ($I_B \leq I_B^{max}$), the Sum-product decoder 17 carries out a calculation of $I_B=I_B+1$ and shifts to the process of (B-1). In contrast, when the variable $I_B$ is larger than $I_B^{max}$ ($I_B>I_B^{max}$), the Sum-product decoder outputs the information sequence shown in the equation (30) and stops the Sum-product decoding.

As can be seen from the above description, in accordance with this Embodiment 1, because the Sum-product decoder 17 is constructed in such a way as to carry out soft-decision iterative decoding on the received signal s' (t) received by the signal receiving unit 12 by using the extended check matrix $H_d$ which is a combination of the matrix D in which the differential modulation by the differential modulator 3 is replaced by a check matrix and the check matrix H for error correcting codes to carry out error correction decoding on an information sequence $b_i$, there is provided an advantage of being able to prevent degradation in the SNR ratio for the bit error rate even through the differential modulator 3 having strong resistance to phase variations is mounted in the transmitter 1. More specifically, because the phase error can be estimated with a high degree of accuracy through the iterative decoding, the degradation of about 3dB in the gain can be prevented by applying synchronous detection also to the communication channel to which differential modulation has to be applied.

Embodiment 2.

Although the example of carrying out soft-decision iterative decoding on the received signal s' (t) received by the signal receiving unit 12 by using the extended check matrix $H_d$ which is a combination of the matrix D in which the differential modulation by the differential modulator 3 is replaced by a check matrix and the check matrix H for error correcting codes is shown in above-mentioned Embodiment 1, a matrix shown in the following equation (31) can be alternatively used as the extended check matrix $H_d$ when replacement is carried out on the codeword sequence by the transmitter 1 and the codeword sequence on which the replacement is carried out is differential-modulated in order to take measures against a burst error or the like.

$$H_d = \left[\frac{R \mid D}{H \mid 0}\right] \qquad (31)$$

where D is a check matrix corresponding to the differential modulation, R is a replacement matrix, 0 is a zero matrix, and H is a check matrix for error correcting codes.

In this case, when the differential modulation which the transmitter 1 carries out is, for example, differential BPSK, a concrete example of the extended check matrix $H_d$ is given by the following equation (32). A codeword sequence for the extended check matrix $H_d$ is shown above the equation (32). The codeword sequence consists of an information sequence b, a parity sequence P, and a transmission codeword sequence U, and the sequence outputted from the transmitter 1 to the transmission line is only the transmission codeword sequence U.

Codeword Sequence for Proposed Check Matrix Shown Below

| Information Sequence b | P | Transmission Code Sequence V |
|---|---|---|

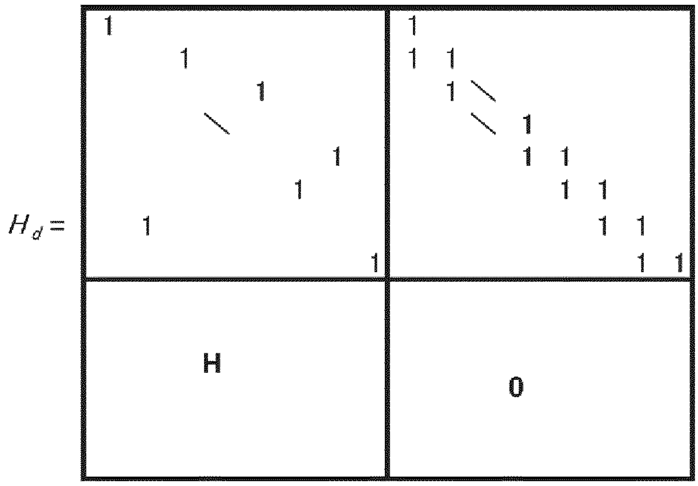


(3 2)

Further, when the differential modulation which the transmitter 1 carries out is, for example, differential QPSK, a concrete example of the extended check matrix $H_d$ is given by the following equation (33). A codeword sequence for the extended check matrix $H_d$ is shown above the equation (33). The codeword sequence consists of an information sequence b, a parity sequence P, and a transmission codeword sequence U, and the sequence outputted from the transmitter 1 to the transmission line is only the transmission codeword sequence U.

Codeword Sequence for Proposed Check Matrix Shown Below

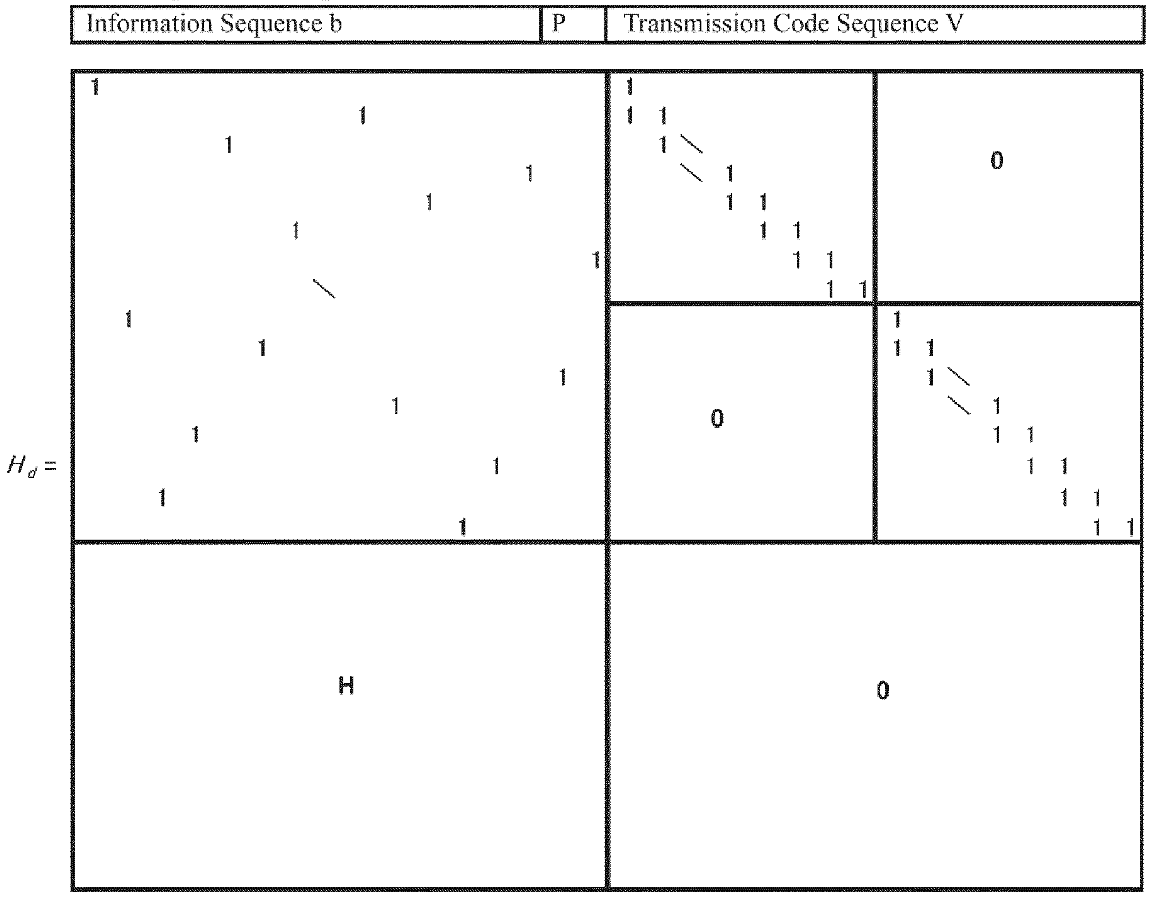


(33)

Embodiment 3.

Although the example in which there is a phase error is shown in above-mentioned Embodiment 1, by using an extended check matrix $H_d$ which is an extension of a check matrix H of LDPC codes even when there is no phase error, there is also provided an advantage of enhancing the performance by adding calculation of the extended portion even when the typical LDPC decoding method in the second step is applied.

Further, although the example of estimating the phase error in the received signal $y_k$ by assuming that the phase error is approximated by a straight line is shown in above-mentioned Embodiment 1, the phase error can be estimated by assuming that the phase error is approximated by a curved line.

Although the example in which the transmitter 1 is assumed to use LDPC coding as error correcting codes is shown in above-mentioned Embodiment 1, any type of error correcting code can be used as long as a soft decision bit can be estimated from error correcting codes.

The present invention can be applied to any communication devices, such as optical communication devices, radio communication devices, cable communication devices, and satellite communication devices.

While the invention has been described in its preferred embodiments, it is to be understood that an arbitrary combination of two or more of the above-mentioned embodiments can be made, various changes can be made in an arbitrary component in accordance with any one of the above-mentioned embodiments, and an arbitrary component in accordance with any one of the above-mentioned embodiments can be omitted within the scope of the invention.

INDUSTRIAL APPLICABILITY

Because the receiver in accordance with the present invention includes the signal receiver that receives a modulated signal of a codeword series outputted to the transmission line from the transmitter that carries out error correction coding on an information sequence so as to generate the codeword series and also carries out differential modulation on the codeword series, and the error correction decoder that carries out soft-decision iterative decoding on the received signal received by the signal receiver by using an extended check matrix which is a combination of a matrix in which the differential modulation is replaced by a check matrix and a check matrix for error correcting codes to carry out error correction decoding on the information sequence, and can prevent degradation in the SNR ratio to the bit error rate even though a differential modulator having strong resistance to phase variations is mounted in the transmitter, the receiver is suitable for use in a communication device that carries optical communications.

EXPLANATIONS OF REFERENCE NUMERALS

1 transmitter, 2 LDPC coder, 3 differential modulator, 11 receiver, 12 signal receiving unit (signal receiver), 13 carrier sensing unit, 14 PLL, 15 frame synchronization unit, 16 demodulator (error correction decoding unit), 17 Sum-product decoder (error correction decoder).

## Claims

1. A receiver comprising:

   a signal receiver that receives a modulated signal of a codeword series outputted to a transmission line from a transmitter that carries out error correction coding on an information sequence so as to generate the codeword series and also carries out differential modulation on said codeword series; and
   an error correction decoder that carries out soft-decision iterative decoding on the received signal received by said signal receiver by using an extended check matrix which is a combination of a matrix in which said differential modulation is replaced by a check matrix and a check matrix for error correcting codes to carry out error correction decoding on said information sequence.

2. A communication device including a transmitter that carries out error correction coding on an information sequence so as to generate a codeword series, and that also carries out differential modulation on said codeword series and outputs a modulated signal of said codeword series to a transmission line, and a receiver that receives the modulated signal of the codeword series outputted from said transmitter to the transmission line, and that carries out error correction decoding on the information sequence, wherein said receiver includes:

   a signal receiver that receives the modulated signal of the codeword series outputted from said transmitter to the transmission line; and an error correction decoder that carries out soft-decision iterative decoding on the received signal received by said signal receiver by using an extended check matrix which is a combination of a matrix in which said differential modulation is replaced by a check matrix and a check matrix for error correcting codes to carry out error correction decoding on said information sequence.

3. The communication device according to claim 2, wherein the error correction decoder carries out the soft-decision iterative decoding on the received signal received by the signal receiver by using the extended check matrix and estimates a phase error of said received signal by using a soft decision bit acquired from results of the decoding and also corrects said received signal by using said phase error, and carries out soft-decision iterative decoding on the corrected received signal by using said extended check matrix to carry out the error correction decoding on the information sequence.

4. The communication device according to claim 2, wherein the error correction decoder uses a matrix $H_d$ shown below as the extended check matrix.

   $$H_d = \left[\frac{I \mid D}{H \mid 0}\right]$$

   where D is the check matrix corresponding to the differential modulation, I is a unit matrix, 0 is a zero matrix, and H is the check matrix for error correcting codes.

5. The communication device according to claim 3, wherein the error correction decoder uses a matrix $H_d$ shown below as the extended check matrix.

$$H_d = \left[\frac{I \mid D}{H \mid 0}\right]$$

where D is the check matrix corresponding to the differential modulation, I is a unit matrix, 0 is a zero matrix, and H is the check matrix for error correcting codes.

6. The communication device according to claim 2, wherein when replacement is carried out on the codeword series by the transmitter and the differential modulation is carried out on the codeword series on which the replacement is carried out, the error correction decoder uses a matrix $H_d$ shown below as the extended check matrix.

$$H_d = \left[\frac{R \mid D}{H \mid 0}\right]$$

where D is the check matrix corresponding to the differential modulation, R is a replacement matrix, 0 is a zero matrix, and H is the check matrix for error correcting codes.

7. The communication device according to claim 3, wherein when replacement is carried out on the codeword series by the transmitter and the differential modulation is carried out on the codeword series on which the replacement is carried out, the error correction decoder uses a matrix $H_d$ shown below as the extended check matrix.

$$H_d = \left[\frac{R \mid D}{H \mid 0}\right]$$

where D is the check matrix corresponding to the differential modulation, R is a replacement matrix, 0 is a zero matrix, and H is the check matrix for error correcting codes.

8. A communication method including the steps of a transmitter carrying out error correction coding on an information sequence so as to generate a codeword series, and also carrying out differential modulation on said codeword series and outputting a modulated signal of said codeword series to a transmission line, and a receiver receiving the modulated signal of the codeword series outputted from said transmitter to the transmission line, and carrying out error correction decoding on the information sequence, wherein said receiver carries out:

a signal receiving process step of receiving the modulated signal of the codeword series outputted from said transmitter to the transmission line; and
an error correction decoding process step of carrying out soft-decision iterative decoding on the received signal received in said signal receiving process step by using an extended check matrix which is a combination of a matrix in which said differential modulation is replaced by a check matrix and a check matrix for error correcting codes to carry out error correction decoding on said information sequence.

FIG.1

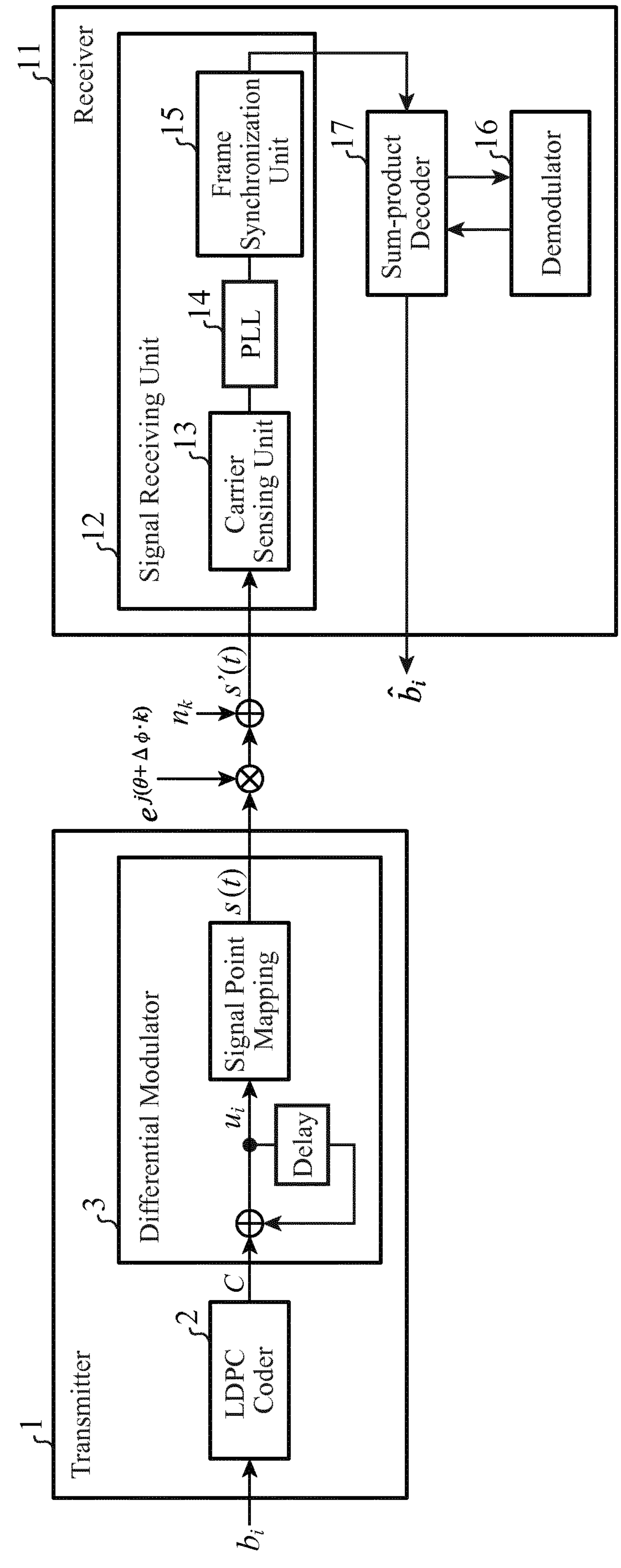
Transmitter
1
LDPC Coder
2
C
Differential Modulator
3
Delay
$u_i$
Signal Point Mapping
$s(t)$
$b_i$
$e^{j(\theta+\Delta\phi\cdot k)}$
$n_k$
$s'(t)$
Receiver
11
Signal Receiving Unit
12
Carrier Sensing Unit
13
PLL
14
Frame Synchronization Unit
15
Sum-product Decoder
17
Demodulator
16
$\hat{b}_i$

FIG.2

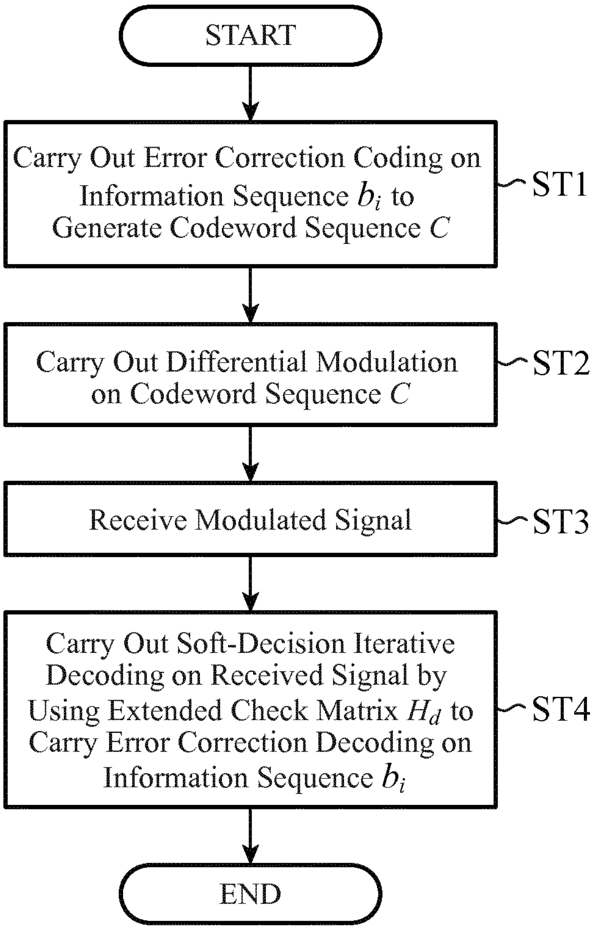
START
Carry Out Error Correction Coding on Information Sequence $b_i$ to Generate Codeword Sequence $C$
ST1
Carry Out Differential Modulation on Codeword Sequence $C$
ST2
Receive Modulated Signal
ST3
Carry Out Soft-Decision Iterative Decoding on Received Signal by Using Extended Check Matrix $H_d$ to Carry Error Correction Decoding on Information Sequence $b_i$
ST4
END

FIG.3

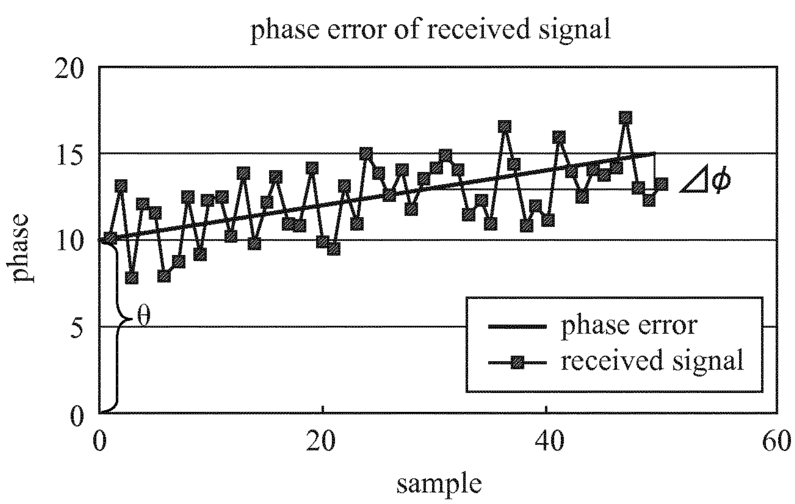
phase error of received signal
phase
sample
0
5
10
15
20
0
20
40
60
θ
Δφ
phase error
received signal

FIG.4

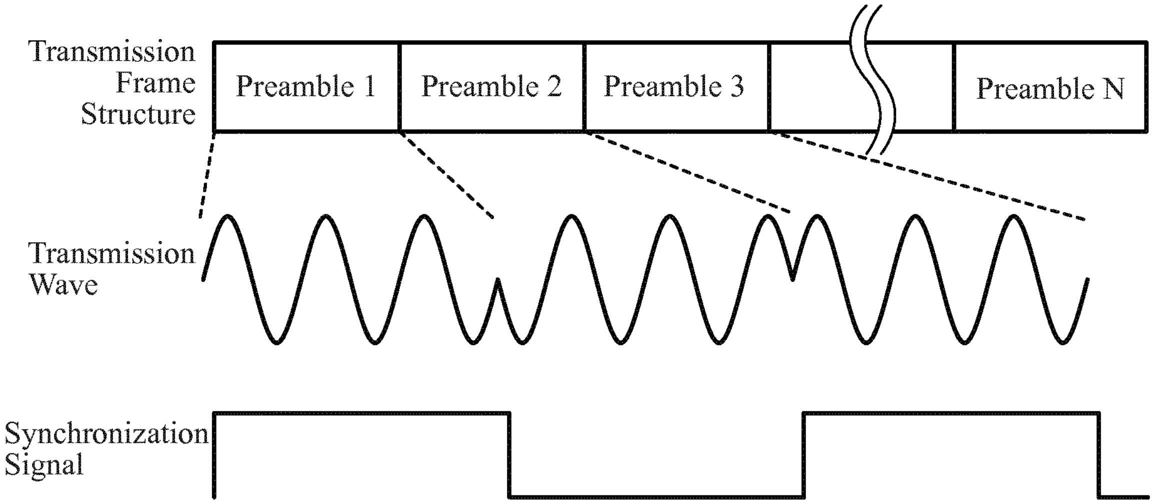
Transmission Frame Structure
Preamble 1
Preamble 2
Preamble 3
Preamble N
Transmission Wave
Synchronization Signal

FIG.5

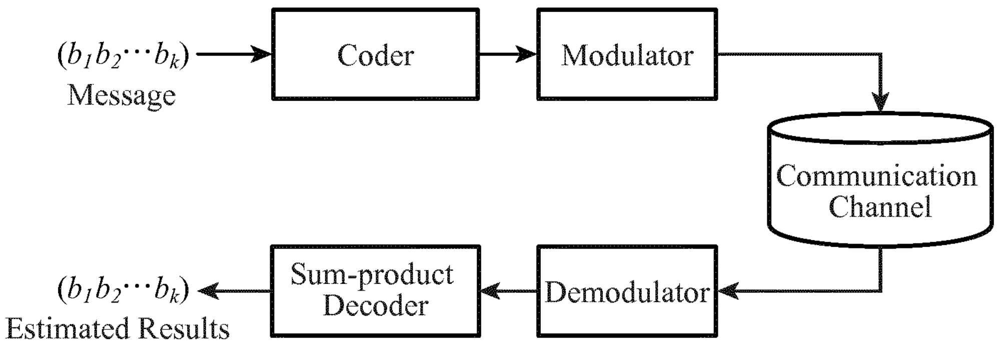
$(b_1 b_2 \cdots b_k)$
Message
Coder
Modulator
Communication Channel
Demodulator
Sum-product Decoder
$(b_1 b_2 \cdots b_k)$
Estimated Results

FIG.6

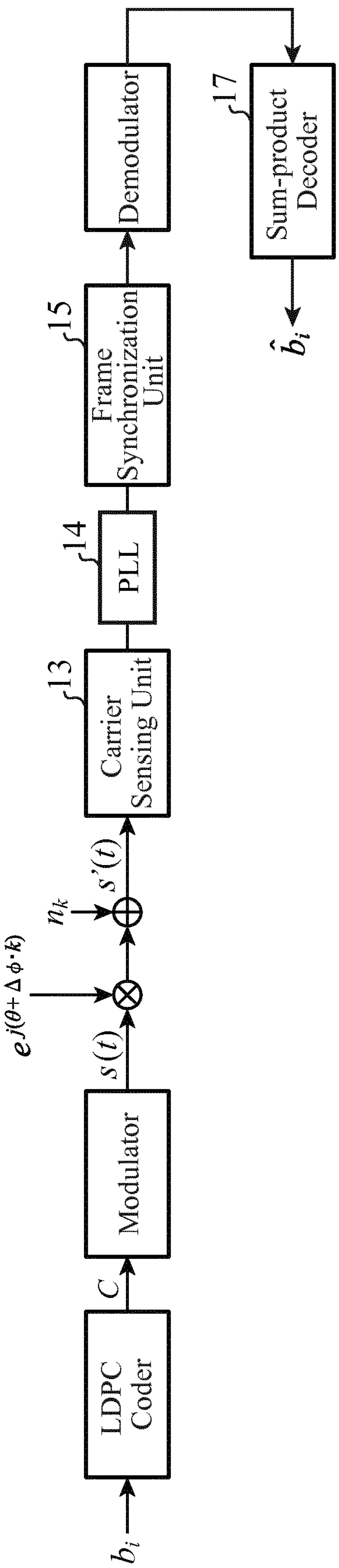
$b_i$
LDPC Coder
$C$
Modulator
$s(t)$
$e^{j(\theta+\Delta\phi\cdot k)}$
$n_k$
$s'(t)$
13
Carrier Sensing Unit
14
PLL
15
Frame Synchronization Unit
Demodulator
17
Sum-product Decoder
$\hat{b}_i$

FIG.7

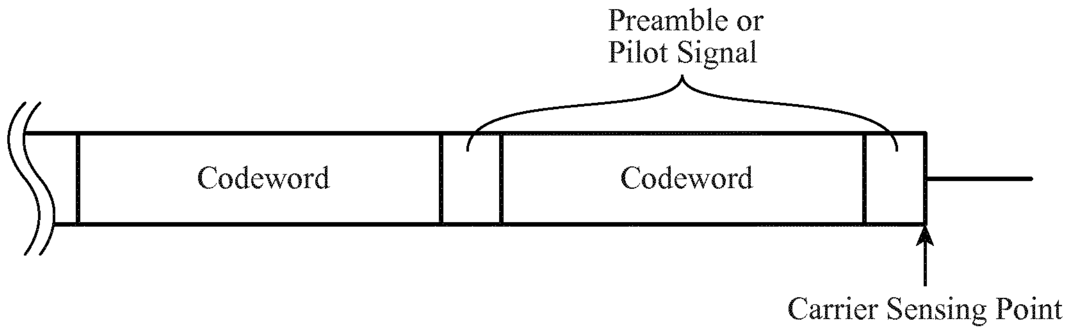
Preamble or
Pilot Signal
Codeword
Codeword
Carrier Sensing Point

FIG.8

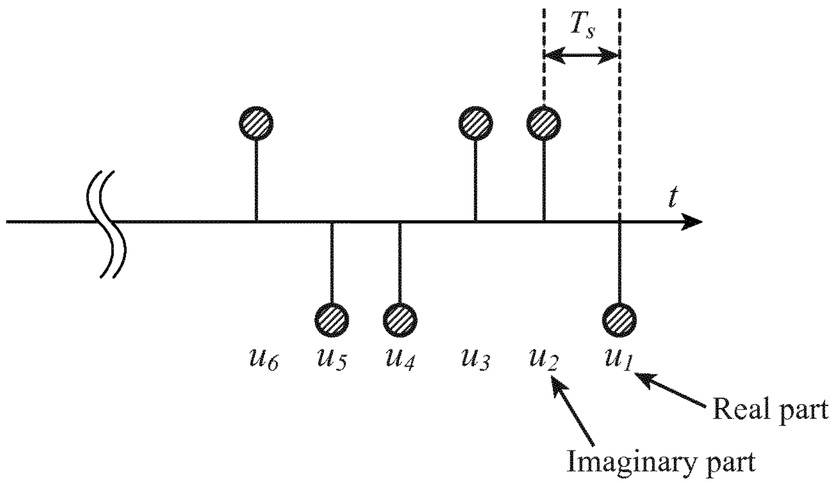
$T_s$
t
$u_6$ $u_5$ $u_4$ $u_3$ $u_2$ $u_1$
Real part
Imaginary part

FIG.9

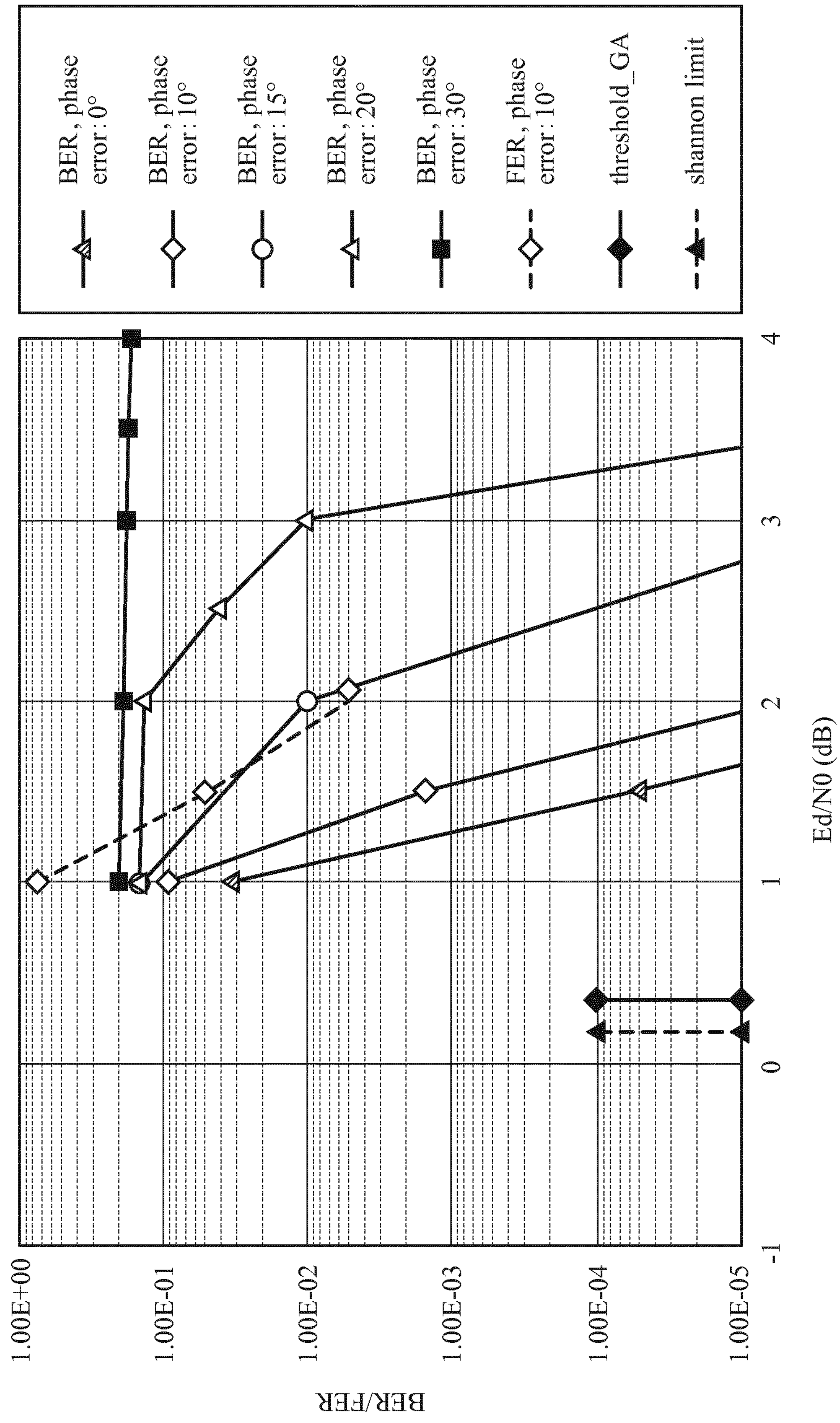
BER, phase error: 0°
BER, phase error: 10°
BER, phase error: 15°
BER, phase error: 20°
BER, phase error: 30°
FER, phase error: 10°
threshold_GA
shannon limit
BER/FER
1.00E+00
1.00E-01
1.00E-02
1.00E-03
1.00E-04
1.00E-05
-1
0
1
2
3
4
Ed/N0 (dB)

FIG.10

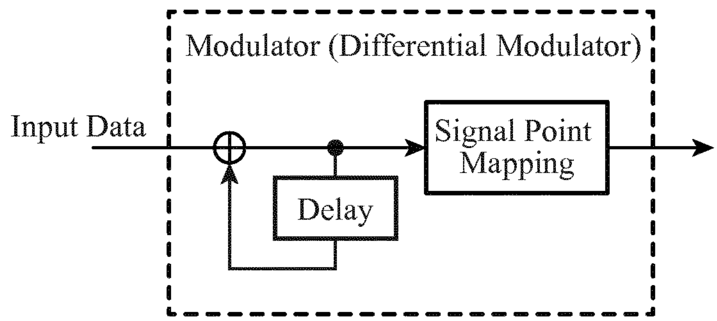
Modulator (Differential Modulator)
Input Data
Delay
Signal Point Mapping

## INTERNATIONAL SEARCH REPORT

International application No.
PCT/JP2013/050568

A. CLASSIFICATION OF SUBJECT MATTER
*H03M13/19*(2006.01)i

According to International Patent Classification (IPC) or to both national classification and IPC

B. FIELDS SEARCHED

Minimum documentation searched (classification system followed by classification symbols)
H03M13/19

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)
IEEE Xplore, CiNii

C. DOCUMENTS CONSIDERED TO BE RELEVANT

| Category* | Citation of document, with indication, where appropriate, of the relevant passages | Relevant to claim No. |
|---|---|---|
| A | Soichiro KAMETANI et al., "An Evaluation for concatenated LDPC and RS FEC with 125Gb/s Polmux RZ-DQPSK (1) FEC Dosa Kensho", 2010 Nen The Institute of Electronics, Information and Communication Engineers Sogo Taikai Koen Ronbunshu Tsushin 2, 02 March 2010 (02.03.2010), page 401, B-10-63 | 1-8 |
| A | Farid Ghani et al., New QC-LDPC codes implementation on FPGA platform in Rayleigh fading environment, Computers & Informatics (ISCI), 2011 IEEE Symposium on, 2011.03.23, pp.206-210 | 1-8 |

☒ Further documents are listed in the continuation of Box C.

☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 08 April, 2013 (08.04.13) | 16 April, 2013 (16.04.13) |

| Name and mailing address of the ISA/ | Authorized officer |
|---|---|
| Japanese Patent Office | |
| Facsimile No. | Telephone No. |

Form PCT/ISA/210 (second sheet) (July 2009)

INTERNATIONAL SEARCH REPORT

International application No.
PCT/JP2013/050568

C (Continuation). DOCUMENTS CONSIDERED TO BE RELEVANT

| Category* | Citation of document, with indication, where appropriate, of the relevant passages | Relevant to claim No. |
|---|---|---|
| A | JP 2009-246797 A (Hiroshima-Shi), 22 October 2009 (22.10.2009), specification, paragraphs [0004] to [0007] (Family: none) | 1-8 |
| A | Hiroshi NISHIMOTO et al., "Blind Iterative Decoding in Bit-Interleaved Coded DPSK", IEICE Technical Report, 27 February 2008 (27.02.2008), vol.107, no.518, pages 193 to 198, RCS2007-218 | 1-8 |
| A | Wataru MATSUMOTO et al., "Blind Synchronization Scheme with Low-Density Parity-Check Codes", The Transactions of the Institute of Electronics, Information and Communication Engineers, 01 October 2003 (01.10.2003), J86-B, no.10, pages 2065 to 2078 | 1-8 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- Blind Synchronization Scheme with Low-Density Parity-Check (LDPC) Codes. **MATSUMOTO ; IMAI.** Information and Communication Engineers Paper Magazine B. Institute of Electronics, October 2003, vol. J86-B, 2065-2078